# EUROPEAN PATENT SPECIFICATION

(11) **EP 0 470 742 B1**
(45) Date of publication and mention of the grant of the patent: **09.04.1997**
(21) Application number: 91306866.4
(22) Date of filing: 26.07.1991
(51) Int. Cl.: G11C 11/409

(54) **Dynamic random access memory**
Dynamischer Direktzugriffspeicher
Mémoire dynamique à accès aléatoire

(30) Priority: 08.08.1990 JP 208316/90
(43) Date of publication of application: 12.02.1992
(73) Proprietor: International Business Machines Corporation, Armonk, N.Y. 10504 (US)
(72) Inventor: Katayama, Yasunao, Sagamihara-shi, Kanagawa-ken (JP); Kirihata, Toshiaki, Matsudo-shi, Chiba-ken (JP); Scheuerlein, Roy E., Sunnyvale, California (US)
(74) Representative: Burt, Roger James, Dr.

(56) References cited:
- EP-A- 0 278 155
- US-A- 4 479 202
- US-A- 4 792 927
- US-A- 4 816 706
- US-A- 4 910 714
- US-A- 5 029 136

## Description

The present invention relates to a semiconductor memory and more particularly pertains to a dynamic random access memory (DRAM) which comprises complementary metal oxide semiconductor field effect transistors (CMOS FET).

CMOS techniques have been applied to single device DRAMs to permit increases in memory density. As memory densities increase, development efforts are being exerted to improve operation speed, power consumption and reliability. Various memory circuit designs have been proposed.

For example, USP 4,816,706 which forms the basis of the preamble of claim 1 discloses a DRAM circuit using the so-called 2/3 VDD bitline precharge scheme. This circuit comprises a memory sense amplifier including a first latch consisting of cross coupled N channel MOS FETs (NMOS FETs) and a second latch consisting of cross coupled P channel MOS FETs (PMOS FETs). A common node of the first latch is connected to ground through an NMOS FET which is controlled by a first latching clock. A common node of the second latch is connected to a supply voltage (VDD) through a PMOS FET which is controlled by a second latching clock. The cross coupled nodes of the first latch are coupled to the cross coupled nodes of the second latch via PMOS FETs whose gates are grounded. A pair of bitlines are coupled to the cross-coupled nodes of the second latch. A further PMOS FET is connected between the bitlines. During a sensing period, the clocks activate the sense amplifier thereby amplifying the potential difference between the bitlines. The voltage of the lower level bitline is pulled down by the first latch until it becomes clamped at the threshold voltage (Vtp) of the ground gate PMOS FETs. In a precharge period following the sensing period, the PMOS FET between the bitlines is turned on to equalise the bitline voltages. After the sensing operation, the higher level bitline is pulled up from the precharge level to VDD by the second latch, while the lower level bitline remains at Vtp. The bitlines are thus precharged to (VDD + Vtp)/2 which approximates to 2/3 VDD.

The memory circuit described USP 4,816,706 achieves high speed sensing, while saving power by limiting the voltage swing of the bitlines within a voltage range of (VDD - ¦VTP¦) where Vtp is the PMOS FET threshold voltage. Furthermore, because the downward swing of the bitline voltage is clamped at ¦VTP¦, the bitline voltage swing is symmetrical relative to the precharge level, even when a 2/3 VDD bitline precharge scheme is used, thereby improving noise immunity. A sensing scheme using the 2/3 VDD bitline precharge system is also described in an article by S. H. Dhong et al. "High-Speed Sensing Scheme for CMOS DRAM'S", IEEE Journal of Solid-State Circuits, Vol. 23, pp. 34 - 40, Feb., 1988.

The PMOS FETs of the memory circuit described in USP4,816,706 operate in a source-follower mode, thus giving high resistances at low voltages. This reduces bitline discharge speed, and thus lowers speeds of write and restore operations.

Japanese Published Unexamined Patent Application No.62-165787 discloses a DRAM having a restore circuit and a sense amplifier coupled through barrier FETs for load capacitance isolation. The restore circuit is composed of a latch consisting of PMOS FETs which are cross-coupled, with the cross-coupled nodes connected to a pair of bitlines. The sense amplifier is composed of a latch consisting of NMOS FETs which are cross-coupled. The cross-coupled nodes of the restore circuit and those of the sense amplifier are coupled through barrier transistors consisting of NMOS FETs. To the gate of each barrier FET, a constant voltage larger than (bitline precharge voltage + threshold voltage of barrier FET)is applied. However, this prior art does not disclose limiting the downward voltage swing of the bitlines by controlling the voltage of the common node of the sense latch and coupling the sense latch to I/O data lines through PMOS FET gates, as in the present invention.

Japanese Published Unexamined Patent Application No 63-197093 discloses a DRAM having a first sense amplifier consisting of cross coupled NMOS FETS and a second sense amplifier consisting of cross coupled PMOS FETs. The cross coupled nodes of the first sense amplifier are directly connected with the cross coupled nodes of the second sense amplifier and are also connected with a pair of bitlines. A precharge voltage generating circuit is connected to the common node of the first sense amplifier. Between the common node of the first sense amplifier and the pair of bitlines, are connected a pair of NMOS FETs which are turned on during the precharging period, and between the common node of the second sense amplifier and a pair of bitlines, are connected a pair of PMOS FETS which are turned on during the precharging period. When the pair of bitlines are equalized to 1/2 VCC (VCC is power supply voltage) by an equalizing FET connected between the pair of bitlines, the precharge voltage generating circuit is also turned on. The precharge voltage generating circuit generates a bitline precharge voltage VBL which is nearly equal to 1/2 VCC, the voltage being coupled to the pair of bitlines and the common node of the second sense amplifier through the pair of NMOS FETs and the pair of PMOS FETs. In this way, the pair of bitlines and the common nodes of both sense amplifiers are reliably precharged to the precharge voltage VBL which is nearly equal to 1/2 VCC.

In accordance with the present invention, as specified by claim 1 there is now provided a dynamic random access memory comprising a sense amplifier including: a latch comprising a pair of NMOS FETs with their gates and drains cross coupled at cross coupled nodes and with their sources connected to a common node; a pair of bitlines coupled to the cross coupled nodes of the latch; means for precharging the bitlines to a precharge voltage; and a latch driving circuit comprising coupling means for coupling a reference voltage to the common node for activating the latch after the bitlines have been precharged; and control means for controlling the voltage of the common node in such a manner that the downward voltage swing of the lower level bitline towards the reference voltage, produced by activation of the latch, is limited to a predetermined voltage level higher than the reference voltage; characterised in that the coupling means includes a first FET connected between the common node and the reference voltage, the first FET being turned on during the sensing period, and turned off when the voltage of the lower level bitline goes down to the predetermined voltage level, and the control means comprises a bitline low voltage generator for generating a bitline low voltage level substantially equal to the predetermined voltage level, and a second FET connected between the common node of the latch and the bitline low voltage level generator, the second FET being turned on when the voltage of the lower level bitline decreases to the predetermined voltage level, thereby coupling the bitline low voltage generator to the common node.

Because any downward voltage swing of the bitlines is limited in this DRAM circuit, higher speed transfer operation between the sense amplifier and the I/O data line can be advantageously effected with lower power consumption and without impairing reliability.

In a second embodiment of the present invention, there is provided a dynamic random access memory comprising: a sense amplifier including a first latch comprising cross coupled FETs of a first conductivity type and having a pair of cross coupled nodes and a common node, and a second latch comprising cross coupled FETs of a second conductivity type and having a pair of cross coupled nodes and a common node, the cross coupled nodes of the first latch being coupled to the cross coupled nodes of the second latch; a pair of bitlines coupled to the cross coupled nodes of the second latch; means for precharging the bitlines to a predetermined precharge voltage during a precharging period; and a latch driving circuit comprising a first terminal coupled to the common node of the first latch, a second terminal connected to a common node of the second latch; characterised in that the latch driving circuit comprises: first means for coupling a first voltage to the first terminal for activating the first latch after the bitlines have been precharged; second means for activating the second latch after the bitlines have been precharged; and third means for coupling a bitline voltage clamping level to the first terminal when a bitline pulled towards the first voltage in response to activation of the first latch reaches a predetermined voltage level, the predetermined voltage level being between the precharge voltage and the first voltage and substantially equal to the bitline voltage clamping level.

The downward voltage swing of the bitlines is limited in accordance with the present invention by controlling the voltage of the common node of the sense latch and coupling the sense latch to I/O data lines through FET gates.

In a third embodiment of the present invention, there is provided a dynamic random access memory comprising: a sense amplifier circuit including a latch comprised of a pair of NMOS FETs with their gates and drains cross-coupled and with their sources connected to a common node, a pair of bitlines coupled to the cross-coupled nodes of the latch and precharged to a predetermined voltage before sensing, and a latch driving circuit coupled to the common node of the latch the latch driving circuit comprising; a first means for coupling a reference voltage to the common node for activation of the latch during a sensing period, a second means for coupling a bitline low voltage level, which is substantially equal to the restore voltage level for a lower level bitline, to the common node during a restoring period to clamp the voltage of the lower level bitline to the restore voltage level, the restore voltage level being higher than the reference voltage, and a third means for coupling a precharge voltage to the common node during said precharging period, the precharge voltage being higher than the bitline low voltage level.

In a fourth embodiment of the present invention, there is provided a dynamic random access memory comprising: a first latch comprised of cross-coupled NMOS FETs and having a pair of cross-coupled nodes and a common node, a second latch comprised of cross-coupled PMOS FETs having a pair of cross-coupled nodes and a common node, isolation FETs connected between the cross-coupled nodes of the first and second latches, a pair of bitlines coupled to the cross-coupled nodes of the second latch and precharged to a predetermined voltage before sensing.

In a fifth embodiment of the present invention, there is provided a dynamic random access memory comprising: a sense amplifier circuit including a latch comprised of a pair of NMOS FETs whose gates and drains are cross-coupled and whose sources are connected to a common node, a pair of bitlines connected to the cross-coupled nodes of the latch, a latch driving circuit coupled to the common node of the latch for activation of the latch at the time of sensing, a pair of data lines precharged to a predetermined high voltage before sensing, and PMOS FET gates for coupling the cross-coupled nodes of the latch to the data lines in response to a control signal.

In a preferred embodiment of the present invention there is provided a DRAM comprising a sense amplifier circuit which has a latch including a pair of cross-coupled NMOS FETs and having a pair of cross-coupled nodes and a common node, a pair of bitlines coupled to the cross-coupled nodes of the latch and precharged to a predetermined voltage before sensing and a latch driving circuit connected to the common node of the latch. The latch driving circuit couples a reference voltage to the common node of the latch for activation of the latch at the time of sensing. The latch driving circuit controls the voltage of the common node of the latch in such a way that the downward voltage swing of a lower level bitline, which is brought about by the activation of the latch, is limited to a predetermined voltage level higher than the reference voltage. This predetermined voltage level provides the restore voltage for the lower level bitline.

The downward voltage swing of the lower level bitline can thus be limited by turning off the FET which couples the common node of the latch to the reference voltage, when the bitline voltage falls to the predetermined voltage level. Therefore, the predetermined bitline low voltage level can be automatically set without power consumption. Further, the bitline low voltage level can be exactly set, irrespective of fluctuations in the manufacturing process, by coupling to the common node of the latch a voltage generator which generates the predetermined bitline low voltage level.

The latch is coupled to the I/O data lines through transfer gates consisting of PMOS FETs. The PMOS FET prevents inversion of the state of the latch by noise produced as the transfergates turn on. The transfer gates can therefore be turned on earlier, thereby permitting the sensed data to be transferred to the data lines at higher speed.

A preferred embodiment of the present invention will now be described with reference to the accompanying drawings, in which:
Figure 1 is a diagram showing a DRAM of this invention;
Figure 2 is a detailed diagram of the latch driving circuit of Figure 1;
Figure 3 is a diagram showing operational waveforms of the DRAM of Figure 1; and
Figure 4 is a diagram showing a prior art DRAM.

Figure 4 shows a DRAM circuit disclosed in the above-mentioned USP 4,816,706. This memory circuit has a memory sense amplifier circuit comprising a first latch consisting of cross-coupled N-channel MOS FETs (NMOS FET) 18 and 20 and a second latch consisting of cross-coupled P-channel MOS FETs (PMOS FET) 14 and 16. A common node 38 of the first latch is connected to ground through an NMOS FET 24 which is controlled by a latching clock φs. A common node 36 of the second latch is connected to a power supply voltage VDD through a PMOS FET 22 which is controlled by another latching clock φsp. The first and second latch circuits are connected through PMOS FETs 10 and 12 whose gates are grounded. Between bitlines 26 and 28, an equalizing device consisting of a PMOS FET 30 is connected.

During the memory sensing period, the sense amplifier circuit is activated by the latching clocks φs and φsp, thereby amplifying the potential difference between the bitlines 26 and 28. The voltage of a lower level bitline is pulled down by the first latch, but the downward swing of the bitline voltage is clamped at the absolute value of the threshold voltage (VTP) of the grounded-gate PMOS FETs 10 and 12. The precharging of the bitlines after the sensing operation is made by equalizing the voltages of the bitlines 26 and 28 by means of the PMOS FET 30. After the sensing operation, the higher level bitline is pulled up from the precharge level to VDD by the second latch, while the lower level bitline remains at the voltage level of ¦VTP¦. Accordingly, by equalization, the bitlines 26 and 28 are precharged to (VDD + ¦VTP¦)/2, normally being at 2/3 VDD.

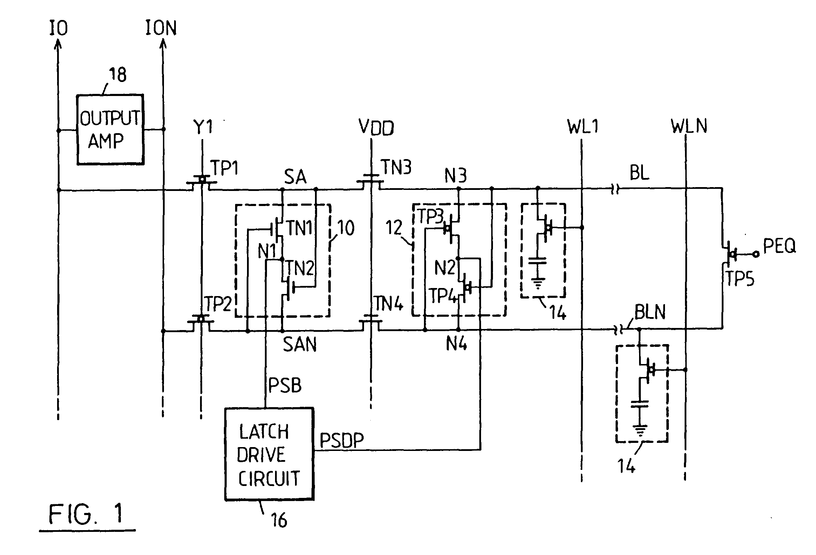

Figure 1 shows the DRAM circuit of the present invention. This memory circuit comprises a first latch 10 consisting of a pair of cross-coupled NMOS FETs TN1 and TN2 and a second latch 12 consisting of a pair of cross-coupled PMOS FETs TP3 and TP4. The gates and drains of the NMOS FETs TN1 and TN2 are cross-coupled, while their sources are connected to a common node N1. The gates and drains of the PMOS FETs TP3 and TP4 are cross-coupled, while their sources are connected to a common node N2. Between the first latch 10 and the second latch 12, NMOS FETs TN3 and TN4 are connected for load capacitance isolation. To the gates of FETs TN3 and TN4, a voltage larger than (VEQ + VTN) (where VEQ denotes the bitline precharge voltage, and VTN the threshold voltage of FET TN3 or TN4) is applied. In this example, a power supply voltage of 3.6V is applied. The common node N1 of the first latch 10 and the common node N2 of the second latch 12 are connected to a latch driving circuit 16. The first latch 10, the second latch 12 and the FETs TN3 and TN4 compose a memory sense amplifier circuit.

The cross-coupled nodes N3 and N4 of the second latch 12 are coupled to a pair of bitlines BL and BLN. At positions defined by the pair of bitlines BL and BLN and word WL1 and WLN, memory cells 14 are provided. In this example, as a switch FET of the memory cell, a PMOS FET is used. Between the pair of bitlines, a PMOS FET TP5 which responds to an equalization signal PEQ is connected.

The cross-coupled nodes SA and SAN of the first latch 10 which act as sense nodes of the sense amplifier circuit are connected to a pair of I/O data lines IO and ION through transfer gates consisting of PMOS FETs TP1 and TP2. The FETs TP1 and TP2 work as column switches or bit switches and are controlled by a column selection signal Y1 from a column decoder. The data lines IO and ION are coupled to a conventional output amplifier circuit 18 of CMOS differential amplifier type. In Figure 1, only one pair of bitlines are depicted. Actually, however, a large number of pairs of such bitlines are provided and a selected pair of bitlines are selectively coupled to the data lines I0 and ION through the column switches.

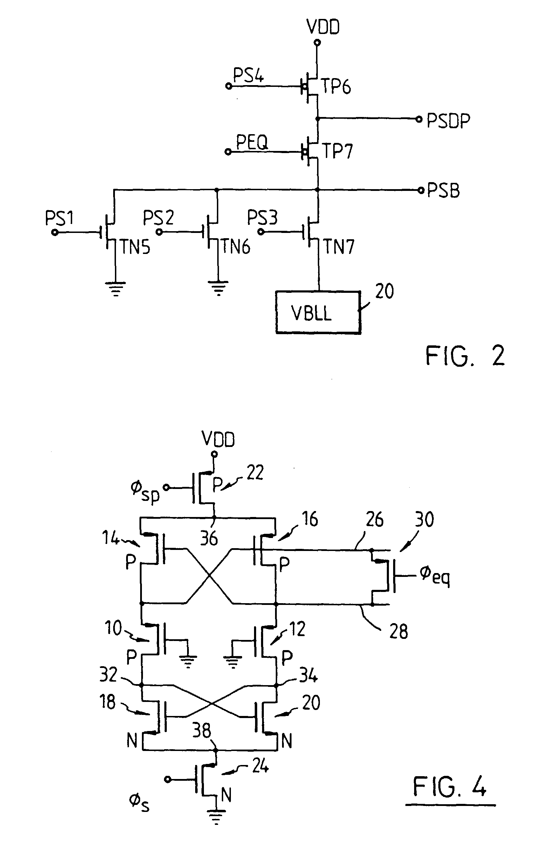

Figure 2 shows the detail of the latch driving circuit 16. The latch driving circuit has an output terminal PSB which is connected to the common node N1 of the first latch 10 and another output terminal PSDP which is connected to the common node N2 of the second latch 12. The driving circuit includes a small NMOS FET TN5 which receives a low speed sense activation signal PS1 during sensing period, a large NMOS FET TN6 which receives a high speed sense activation signal PS2 and an NMOS FET TN7 which receives a bitline low voltage level clamping signal SP3 during restoring period. The drains of TN5, TN6 and TN7 are commonly connected to the output terminal PSB and the sources of TN5 and TN6 are each connected to a reference voltage selected as the ground voltage. The source of TN7 is connected to a bitline low voltage level generator 20. Between a power supply voltage VDD and the output terminal PSDP, a PMOS FET TP6 which receives a signal PS4 for activating the second latch 12 is connected, and between the output terminals PSDP and PSB, a PMOS FET TP7 which receives the equalization signal PEQ is connected.

In the following, the operation of this system is described with reference to Figures 1 - 3:

### Sensing operation

The sensing operation itself is basically identical with the conventional DRAMs which use low and high speed sensing. Before starting the sensing operation, the pair of bitlines BL and BLN and the latch nodes SA and SAN are at an equalized precharge voltage VEQ. When a selected wordline is brought to a low level, the associated memory cell is read out. Then, a differential voltage is generated between the pair of bitlines in correspondence with the memory value. The voltages of the bitlines are coupled to the latch nodes SA and SAN through the FETs TN3 and TN4 which are biased in a conductive state.

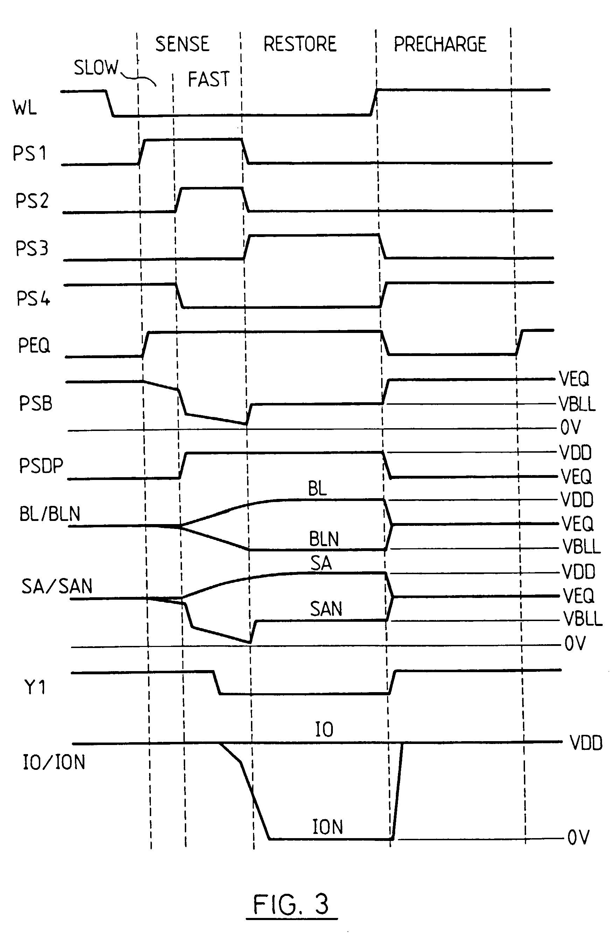

As the low speed sense activation signal PS1 goes up to a high level, TN5 slightly conducts, causing the voltage of terminal PSB to go down slowly, whereby the first latch 10 begins to amplify the potential difference between the latch nodes SA and SAN. Next, the high speed sense activation signal PS2 goes up to a high level and the second latch activation signal PS4 falls to a low level. By the signal PS2, TN6 strongly conducts, thereby accelerating the fall of the voltage of the terminal PSB. Consequently, the first latch 10 pulls down a lower level bitline toward 0V. For instance, in the example shown in Figure 3, the lower level bitline pulled down is BLN and thus the corresponding latch node SAN is pulled down. Since at this time, the equalization signal PEQ is at a high level and so FET TP7 is off, the terminal PSDP is coupled to the power supply voltage through TP6, whereby the higher level bitline and its corresponding latch node, for example, BL and SA, are pulled up from the precharge voltage VEQ to the power supply voltage VDD.

The NMOS FETs TN3 and TN4 isolate the latch nodes SA and SAN from the bitline capacitances, thereby providing a high speed latching operation.

Then, the column selection signal Y1 goes down to a low level during the sensing period, thereby coupling the sense nodes SA and SAN to the data lines 10 and ION. The data lines IO and ION are precharged to VDD before the readout operation, so that the data line ION coupled to the lower level sense node SAN is discharged through the latch 10. The data line coupled to the higher level sense node SA provides the voltage of VDD to the gate of the conductive FET of the latch 10 TN2 in this example, thereby accelerating the discharge of the data line ION. The differential voltage between the data lines is further amplified by the output amplifier 18 and the voltage on the lower level data line ION goes down to 0V.

One feature of this invention lies in clamping at a predetermined bitline low voltage level the downward voltage swing of the lower level bitline BLN, which swing occurs due to the activation of the first latch 10, by means of the voltage control of the common node N1 of the first latch 10. When the FETs TN5 and TN6 continue to conduct, the voltage on the lower level bitline will fall to nearly 0V. However, according to this invention, when the voltage of the lower level bitline BLN goes down to a predetermined bitline low voltage level VBLL corresponding to the low level restore voltage, PS1 and PS2 become low, thereby turning the FETs TN5 and TN6 off. Accordingly, the low level restore voltage is automatically given to the lower level hitline.

However, due to fluctuations in the manufacturing process, it may be difficult to exactly set the predetermined low level restore voltage to the lower level bitline by only turning off TN5 and TN6.
Accordingly, a bitline low voltage level generator 20 which generates a bitline low voltage level VBLL substantially equal to the predetermined low level restore voltage is coupled to the common node N1 of the latch 10.

TN5 and TN6 are turned off at the time when the lower level bitline BLN goes down to the predetermined bitline low voltage level VBLL, and simultaneously the bitline low voltage level clamping signal PS3 is made high. Then TN7 is turned on, thereby coupling the reference voltage level VBLL to the common node N1 to forcibly set the low level restore voltage to the lower level bitline BLN. The timing appropriate for turning off TN5 and TN6 and turning on TN7 can be determined with ease by analysis of circuit operations. The bitline low voltage level generator 20 is, of course, unnecessary, when it is possible to exactly set the bitline low voltage level VBLL by simply turning off TN5 and TN6.

Another feature of this invention is that PMOS FETs TP1 and TP2 are used as column switches. When NMOS FETs are used as column switches, the column switch connected to the lower level sense node will have a large gate - source voltage VGS. Accordingly, a relatively large transient noise current will flow through the column switch at the time of turn-on transition of the column switch. This noise current tends to cause the voltage of the lower level sense node to go up and if the latch 10 is not adequately set, there is a possibility of causing the state of the latch 10 to be inverted, resulting in an erroneous operation. Accordingly, when NMOS FETs are used as column switches, the column switches must be turned on, after the latch 10 has been adequately set. When PMOS FETs are used as column switches, the sources of both the FETs are at the precharge voltage VDD of the data lines. Therefore, the gate-source voltages of both the FETs are equal. Accordingly, the PMOS FETs work as mirror current sources at the time of turn-on transition, so that the transient noise currents through the FETs are substantially cancelled, thus barely affecting the state of latch 10. Consequently, the column switches TP1 and TP2 can be turned on at earlier timing before the bitline voltages reach the final levels, so that the sensed data can be transferred to the data lines earlier, thereby enabling the memory cycle to be shortened. It should be noted that, as seen in Figure 3, the column selection signal Y1 is turned on earlier, near the middle of the high speed sensing period. Further, before the bitline voltages reach the final levels, the column switches are turned on, whereby the data line voltage VDD is coupled to the conductive side FET of the latch 10. Consequently, the drive of the latch 10 is accelerated, thus resulting in a still higher speed sensing operation.

### Restoring operation

After the sensing operation, the restoring operation or rewriting is performed. The restoring operation is started, when, as above-described, the signals PS1 and PS2 go low, and PS3 high. At this time, the voltage of the lower level bitline is at the bitline low voltage level VBLL corresponding to the lower level restore voltage, while the voltage of the higher level bitline is VDD. Accordingly, one of binary values is restored as a voltage VBLL, and the other is restored as VDD, respectively.

If TN6 continues to conduct, the node N1 of the latch 10 will be pulled down to about 0V, but according to this invention, it is clamped at VBLL before the node goes down to 0V. Accordingly, the voltage swing at the latch nodes SA/SAN is limited, resulting in a reduction in power consumption.

### Precharging operation

During the precharging period, the signal PS3 goes to a low level, and PS4 to a high level, while the equalization signal PEQ goes to a low level. Accordingly, TP6 and TN7 are turned off, while TP7 is turned on. Since the terminal PSDP has been charged to a voltage of VDD and the terminal PSB has been charged to a voltage of VBLL, as TP7 turns on, the voltages at the terminals PSB and PSDB are equalized to a voltage of VEQ = (VDD + VBLL)/2; thus, this voltage is given to the common nodes N1 and N2.

On the other hand, the equalizing FET TP5 is concurrently turned on to equalize the pair of bitlines, thus precharging them at a voltage of (VDD + VBLL)/2. By the combination of the equalization by the equalizing FET TP5 and the supply of the precharge voltage from the latch driving circuit 16, the pair of bitlines are rapidly precharged. VDD is 3.6V, and VBLL is about 1/3 VDD = 1.2V, for example. Accordingly, the precharge voltage VEQ is about 2.4V or 2/3 VDD.

According to the present invention, NMOS FETs TN3 and TN4 are used as load isolation FETs, but it is also possible to use PMOS FETs which are biased by a negative voltage to a fully conductive state. However, PMOS FETs are undesirable, because it is difficult to fabricate a PMOS FET having a definite threshold value and because an extra negative voltage source becomes necessary. It is necessary that the conductances of FET TN3 and TN4 are sufficiently high to permit high speed charge transfer between the bitlines and the sensing nodes at the sensing time as well as providing high speed restore and write operations, but are sufficiently low to provide effective isolation of the sensing nodes from the bitline capacitances. Further, in the above-described embodiment of the present invention, NMOS FETs are used for the first latch 10, and PMOS FETs for the second latch 12, but it is also possible to use PMOS FETs for the first latch 10, and NMOS FETs as the second latch 12. In this instance, however, the voltage values of the latch driving circuit 16, the conductivity types of the FETs, and the polarities of the control signals need to be reversed. In this alternative, the precharge voltage is 1/3 VDD, the bitline clamping level generator 20 generates 2/3 VDD and the upward voltage swing of the higher level bitline is clamped at 2/3 VDD. Accordingly, the voltage of the bitlines will swing between 0V and 2/3 VDD. However, it is difficult to fabricate a PMOS FET having a definite threshold value and accordingly, the data latching timing tends to be unstable. On this account, it is preferable to use NMOS FETs for the first latch 10, and PMOS FETs for the second latch.

It will now be appreciated that the present invention offers the following advantages
(1) The common node of the NMOS latch is coupled to the bitline low level reference voltage at the sensing time to clamp the bitline downward voltage swing. Accordingly, the bitline low voltage level can be readily set, without substantially affecting the sense and write operations. In this system, NMOS FETs can be used as load isolation FETs.
(2) As the column switches, PMOS FETs are used. Before the bitline voltages reach the final levels, the column switches may be turned on earlier. Accordingly, it is possible to rapidly make data transfer to the data lines as well as to accelerate the drive of the NMOS latch, thereby performing a higher speed latch operation.
(3) Power consumption is low, because the voltage swing of the nodes SA/SAN of the sense amplifier is limited.

## Claims

1. A dynamic random access memory comprising a sense amplifier including: a latch (10) comprising a pair of NMOS FETs (TN1, TN2) with their gates and drains cross coupled at cross coupled nodes (SAN, SA) and with their sources connected to a common node (N1); a pair of bitlines (BL, BLN) coupled to the cross coupled nodes (SAN, SA) of the latch (10); means (TP5) for precharging the bitlines to a precharge voltage; and a latch driving circuit (16) comprising coupling means (TN5, TN6) for coupling a reference voltage to the common node for activating the latch (10) after the bitlines have been precharged; and control means (TN7, 20) for controlling the voltage of the common node in such a manner that the downward voltage swing of the lower level bitline towards the reference voltage, produced by activation of the latch (10), is limited to a predetermined voltage level higher than the reference voltage; characterised in that the coupling means (TN5, TN6) includes a first FET (TN6) connected between the common node and the reference voltage, the first FET (TN6) being turned on during the sensing period, and turned off when the voltage of the lower level bitline goes down to the predetermined voltage level, and the control means (TN7, 20) comprises a bitline low voltage generator (20) for generating a bitline low voltage level substantially equal to the predetermined voltage level, and a second FET (TN7) connected between the common node of the latch and the bitline low voltage level generator (20), the second FET (TN7) being turned on when the voltage of the lower level bitline decreases to the predetermined voltage level, thereby coupling the bitline low voltage generator (20) to the common node.

2. A memory as claimed in claim 1 wherein the predetermined voltage level has a value intermediate between the precharge voltage and the reference voltage.

3. A memory as claimed in claim 1, wherein the bitline low voltage level provides a restore voltage level for the lower bitline.

4. A memory as claimed in claim 3, wherein the latch driving circuit (16) further comprises means (TP7) for coupling a voltage substantially equal to the precharge voltage to the common node during the precharge period.

## Patentansprüche

1. Ein dynamischer Direktzugriffsspeicher mit einem Leseverstärker, der über folgendes verfügt: eine Verriegelung (10) mit einem Paar NMOS FETs (TN1, TN2), deren Gates und Drains an die quer gekoppelten Knoten (SAN, SA) quer gekoppelt sind und deren Sources an einen gemeinsamen Knoten (N1) angeschlossen sind; ein Paar Bitleitungen (BL, BLN), die mit den quer gekoppelten Knoten (SAN, SA) der Verriegelung (10) verbunden sind; ein Mittel (TP5) zum Vorladen der Bitleitungen auf eine Vorladespannung; einen Verriegelungsantriebsschaltkreis (16) mit Kopplungsmitteln (TN5, TN6) zum Koppeln einer Bezugsspannung an den gemeinsamen Knoten, um die Verriegelung (10) nach der Vorladung der Bitleitungen zu aktivieren, und Kontrollmittel (TN7, 20) zur Kontrolle der Spannung des gemeinsamen Knotens, so daß die durch die Aktivierung der Verriegelung verursachte Abwärtsspannungsschwingung der Niedrigpegel-Bitleitung zur Bezugsspannung auf einen festgelegten Spannungspegel beschränkt wird, der höher als die Bezugsspannung ist; wobei dies dadurch gekennzeichnet ist, daß die Kopplungsmittel (TN5, TN6) einen ersten FET (TN6) umfassen, der zwischen dem allgemeinen Knoten und der Bezugsspannung angeschlossen ist, wobei der erste FET (TN6) in der Lesephase eingeschaltet wird, und ausgeschaltet wird, wenn die Spannung der Niedrigpegel-Bitleitung auf den festgelegten Spannungspegel sinkt, und die Kontrollmittel (TN7, 20) einen Bitleitungs-Niedrigspannungsgenerator (20) zur Erzeugung eines Bitleitungs-Niedrigspannungspegels umfassen, der im wesentlichen dem festgelegten Spannungspegel entspricht, und einen zweiten FET (TN7) zwischen dem gemeinsamen Knoten der Verriegelung und dem Bitleitungs-Niedrigspannungsgenerator (20), wobei der zweite FET (TN7) eingeschaltet wird, wenn die Spannung der Niedrigpegel-Bitleitung auf den festgelegten Spannungspegel fällt, wodurch der Bitleitungs-Niedrigspannungsgenerator (20) an den gemeinsamen Knoten gekoppelt wird.

2. Ein Speicher nach Anspruch 1, bei dem der festgelegte Spannungspegel einen Wert zwischen der Vorladespannung und der Bezugsspannung hat.

3. Ein Speicher nach Anspruch 1, bei der der Bitleitungs-Niedrigspannungspegel einen Wiederherstellungsspannungspegel für die Niedrigbitleitung bereitstellt.

4. Ein Speicher nach Anspruch 3, bei dem der Verriegelungsantriebsschaltkreis (16) weiterhin ein Mittel (TP7) zum Koppeln einer Spannung, die im wesentlichen der Vorladespannung entspricht, an den gemeinsamen Knoten während der Vorladephase umfaßt.

## Revendications

1. Mémoire vive dynamique comprenant un amplificateur de lecture qui comporte : un circuit à verrouillage (10) comprenant une paire de transistors à effet de champ (FET) métal oxyde semiconducteur (MOS) de type n (TN1, TN2), dont les grilles et les drains sont couplés transversalement au niveau de noeuds de couplage transversal (SAN, SA), et dont les sources sont reliées à un noeud commun (N1), une paire de lignes de bits (BL, BLN) couplée au noeud de couplage transversal (SAN, SA) du circuit à verrouillage (10), un moyen (TP5) destiné à précharger les lignes de bits à une tension de précharge, et un circuit d'attaque de circuit à verrouillage (16) comprenant un moyen de couplage (TN5, TN6) destiné à coupler une tension de référence au noeud commun afin d'activer le circuit à verrouillage (10) après que des lignes de bits aient été préchargées, et un moyen de commande (TN7, 20) destiné à commander la tension du noeud commun d'une manière telle que l'excursion en tension descendante de la ligne de bits du niveau inférieur vers la tension de référence, produite par l'activation du circuit à verrouillage (10) est limitée à un niveau de tension prédéterminé plus élevé que la tension de référence, caractérisée en ce que le moyen de couplage (TN5, TN6) comprend un premier transistor à effet de champ (TN6) relié entre le noeud commun et la tension de référence, le premier transistor à effet de champ (TN6) étant activé pendant la période de lecture, et étant désactivé lorsque la tension de la ligne de bits du niveau inférieur passe à l'état bas jusqu'au niveau de tension prédéterminé, et le moyen de commande (TN7, 20) comprend un générateur de basse tension de ligne de bits (20) destiné à générer un niveau de tension bas de ligne de bits pratiquement égal au niveau de tension prédéterminé, et un second transistor à effet de champ (TN7) relié entre le noeud commun du circuit à verrouillage et le générateur de niveau de tension basse de ligne de bits (20), le second transistor à effet de champ (TN7) étant activé lorsque la tension de la ligne de bits de niveau inférieur diminue jusqu'au niveau de tension prédéterminé, en couplant ainsi au noeud commun le générateur de basse tension de ligne de bits (20).

2. Mémoire selon la revendication 1, dans laquelle le niveau de tension prédéterminé présente une valeur intermédiaire entre la tension de précharge et la tension de référence.

3. Mémoire selon la revendication 1, dans laquelle le niveau de tension basse de ligne de bits applique un niveau de tension de rétablissement à la ligne de bits inférieure.

4. Mémoire selon la revendication 3, dans laquelle le circuit d'attaque de circuit à verrouillage (16) comprend en outre un moyen (TP7) destiné à coupler une tension pratiquement égale à la tension de précharge au noeud commun pendant la période de précharge.
